(19) Europäisches Patentamt
European Patent Office
Office européen des brevets

(11) **EP 4 464 534 A1**

(12) **EUROPEAN PATENT APPLICATION**

(43) Date of publication:
**20.11.2024 Bulletin 2024/47**

(21) Application number: **23213518.6**

(22) Date of filing: **30.11.2023**

(51) International Patent Classification (IPC):
**B60L 3/00** (2019.01)   **B60L 58/14** (2019.01)
**B60L 58/16** (2019.01)   **G01R 31/36** (2020.01)
**G01R 31/367** (2019.01)   **G01R 31/389** (2019.01)

(52) Cooperative Patent Classification (CPC):
**B60L 3/0046; B60L 58/14; B60L 58/16;**
B60L 2240/547; G01R 31/007; G01R 31/3647;
G01R 31/367; G01R 31/389; Y02T 10/70

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.05.2023 CN 202310565563**

(71) Applicant: **Chongqing Changan Automobile Co.,
Ltd.**
**Chongqing 400023 (CN)**

(72) Inventors:
• **WEN, Tao**
  **Chongqing, 400023 (CN)**
• **HE, Wen**
  **Chongqing, 400023 (CN)**
• **ZHANG, Peng**
  **Chongqing, 400023 (CN)**
• **TANG, Junhua**
  **Chongqing, 400023 (CN)**
• **CAI, Jiajia**
  **Chongqing, 400023 (CN)**

(74) Representative: **Schulz Junghans
Patentanwälte PartGmbB
Großbeerenstraße 71
10963 Berlin (DE)**

(54) **METHOD AND SYSTEM FOR PREDICTING INSUFFICIENT VOLTAGE PROBABILITY OF VEHICLE, AND CLOUD SERVER**

(57)   A method and system for predicting an insufficient voltage probability of a vehicle, and a cloud server are disclosed. The method is applied to a cloud server. The cloud server communicates with a vehicle infotainment apparatus. The method includes: obtaining a plurality of initial starting data sets of a storage battery uploaded by the vehicle infotainment apparatus within preset time respectively; determining, based on each initial starting data set by using a target internal resistance prediction algorithm, predicted internal resistance corresponding to each initial starting data set, to obtain a plurality of pieces of predicted internal resistance; determining target internal resistance based on the plurality of pieces of predicted internal resistance; obtaining a historical vehicle data set uploaded by the vehicle infotainment apparatus; and determining an insufficient voltage probability of a vehicle based on the target internal resistance and the historical vehicle data set. Internal resistance prediction is performed based on cloud big data, a prediction result can be calibrated, and the insufficient voltage probability of the vehicle is determined by considering a plurality of influencing factors and combining historical vehicle data. This helps improve accuracy of a calculation result.

Fig. 2

**Description**

**Field of the Invention**

The present disclosure relates to the field of vehicle technologies, and in particular, to a method and system for predicting an insufficient voltage probability of a vehicle, and a cloud server.

**Background of the Invention**

With the continuous improvement of the degree of automobile intelligence, use of electricity in vehicles is also increasing. At present, a fuel vehicle, a hybrid vehicle, or an electric vehicle operates normally on a premise that a small battery for starting can operate normally. However, as a number of years of usage increases, a service life of the small battery may be different for different habits of users in using the vehicle and different states of the vehicle, but the small battery finally ages, resulting in an insufficient voltage of the vehicle and further making the vehicle unavailable for the user. At present, a main reason for poor user experience is that the vehicle suddenly fails to start without warning. Based on the above situation, how to determine and remind the user of an aging status of the battery and an insufficient voltage probability of the vehicle becomes increasingly important. At present, the automotive industry, colleges, and the like have proposed some solutions for a subject of storage battery aging prediction. However, there is still some room for optimization in the current solutions.

In the prior art, there is generally no restriction on a precondition for calculating internal resistance. Under different temperatures and/or a low state of charge (SOC), a voltage and a current fluctuate greatly, the calculated internal resistance may be deviated, and a final insufficient voltage probability of the vehicle cannot be obtained. Alternatively, in the prior art, the insufficient voltage probability is determined based on only charge acceptance of the storage battery, without considering impact of the temperature on the charge acceptance of the storage battery, nor considering existence of a plurality of aging modes of the storage battery, and consequently, there is a large error in the insufficient voltage probability. Therefore, a method for predicting an insufficient voltage probability of a vehicle in the prior art has a problem that a prediction result is not so accurate because various influencing factors in a real environment are not considered.

**Summary of the Invention**

An objective of embodiments of the present application is to provide a method and system for predicting an insufficient voltage probability of a vehicle, and a cloud server, to solve a problem of a method for predicting an insufficient voltage probability of a vehicle in the prior art that a prediction result is inaccurate because various influencing factors in a real environment are not considered.

To achieve the foregoing objective, a first aspect of the present application provides a method for predicting an insufficient voltage probability of a vehicle. The method is applied to a cloud server. The cloud server communicates with a vehicle infotainment apparatus. The method includes:

> obtaining a plurality of initial starting data sets of a storage battery uploaded by the vehicle infotainment apparatus within preset time respectively;
>
> determining, based on each initial starting data set by using a target internal resistance prediction algorithm, predicted internal resistance corresponding to each initial starting data set, to obtain a plurality of pieces of predicted internal resistance;
>
> determining target internal resistance based on the plurality of pieces of predicted internal resistance;
>
> obtaining a historical vehicle data set uploaded by the vehicle infotainment apparatus; and
>
> determining an insufficient voltage probability of a vehicle based on the target internal resistance and the historical vehicle data set.

In this embodiment of the present application, the determining, based on each initial starting data set by using a target internal resistance prediction algorithm, predicted internal resistance corresponding to each initial starting data set includes:

> for any initial starting data set, preprocessing the any initial starting data set to obtain a target starting data set;
>
> obtaining an initial internal resistance prediction algorithm;
>
> performing algorithm conversion on the initial internal resistance prediction algorithm to obtain the target internal resistance prediction algorithm; and
>
> running the target starting data set by using the target internal resistance prediction algorithm, to obtain predicted internal resistance corresponding to the any initial starting data set.

The target starting data set includes:
starting voltage data, starting current data, a state of charge value, and temperature data.

In this embodiment of the present application, the running the target starting data set by using the target internal resistance prediction algorithm, to obtain predicted internal resistance corresponding to the any initial starting data set includes:

determining whether the target starting data set satisfies a specified condition;

when the target starting data set satisfies the specified condition, obtaining a starting voltage distribution map and a starting current distribution map based on the starting voltage data and the starting current data respectively;

determining, based on the starting voltage distribution map and the starting current distribution map, whether the target starting data set is a valid starting data set; and

when the target starting data set is a valid starting data set, determining the predicted internal resistance based on the starting voltage distribution map and the starting current distribution map.

The specified condition is that first obtained temperature data in the target starting data set satisfies a preset temperature range and a first obtained state of charge value in the target starting data set is greater than a specified state of charge value.

In this embodiment of the present application, the determining, based on the starting voltage distribution map and the starting current distribution map, whether the target starting data set is a valid starting data set includes:

analyzing, based on the starting voltage distribution map and the starting current distribution map, a voltage and current waveform generated after the vehicle starts; and

when the voltage and current waveform satisfies a first feature, determining that the target starting data set is a valid starting data set; or

when the voltage and current waveform satisfies a second feature, determining that the target starting data set is an invalid starting data set.

In this embodiment of the present application, the determining the predicted internal resistance based on the starting voltage distribution map and the starting current distribution map includes:

determining, based on the starting voltage distribution map, a voltage minimum and a steady-state voltage value that correspond to the target starting data set;

determining, based on the starting current distribution map, a current minimum and a steady-state current value that correspond to the target starting data set; and

determining the predicted internal resistance based on the voltage minimum value, the steady-state voltage value, the current minimum, and the steady-state current value.

In this embodiment of the present application, the determining an insufficient voltage probability of a vehicle based on the target internal resistance and the historical vehicle data set includes:

determining whether the target internal resistance is greater than preset internal resistance; and

when the target internal resistance is greater than the preset internal resistance, determining the insufficient voltage probability of the vehicle based on the historical vehicle data set.

In this embodiment of the present application, the historical vehicle data set includes:
a historical warning record for an abnormality of the vehicle, a number of times the vehicle fails to start, a number of times the vehicle is parked for a preset number of days, a vehicle using habit record of a user, and an average battery power record.

In this embodiment of the present application, the cloud server further communicates with a mobile terminal. The method further includes:
when the insufficient voltage probability is greater than a warning threshold, sending a prompt signal to the mobile terminal and the vehicle infotainment apparatus.

A second aspect of the present application provides a cloud server, including:

a memory, configured to store instructions; and

a processor, configured to invoke the instructions from the memory and capable of implementing, when executing the instructions, the foregoing method for predicting an insufficient voltage probability of a vehicle.

A third aspect of the present application provides a system for predicting an insufficient voltage probability of a vehicle. The system includes:

the foregoing cloud server; and

a vehicle infotainment apparatus, communicating with the cloud server and configured to upload a plurality of initial starting data sets of a storage battery to the cloud server and receive a prompt signal sent by the cloud server.

In this embodiment of the present application, the system further includes:

a mobile terminal, communicating with the cloud server and configured to receive the prompt signal sent by the cloud server.

A fourth aspect of the present application provides a machine-readable storage medium. Instructions are stored on the machine-readable storage medium. The instructions are used for enabling a machine to perform the foregoing method for predicting an insufficient voltage probability of a vehicle.

The present disclosure has the following beneficial effects.

(1) In the present disclosure, internal resistance prediction is performed based on cloud big data, and a prediction result can be calibrated, so that accuracy of the prediction result is improved.

(2) In the present disclosure, the insufficient voltage probability of the vehicle is determined by considering a plurality of influencing factors and combining the predicted internal resistance and historical vehicle data. This helps the user directly learn about an aging condition of the storage battery and respond in time. Therefore, user experience in using the vehicle is improved.

Other features and advantages of the embodiments of the present application will be subsequently described in detail in Detailed Description of the Embodiments.

**Brief Description of the Drawings**

The drawings, which constitute a part of the specification, are used to provide further understandings of the embodiments of the present application and explain, together with the following specific implementation modes, the embodiments of the present application and not intended to form limitations on the embodiments of the present application. In the drawings:

Fig. 1 is a schematic diagram of a structure of a system for predicting an insufficient voltage probability of a vehicle according to an embodiment of the present application;

Fig. 2 is a schematic flowchart of a method for predicting an insufficient voltage probability of a vehicle according to an embodiment of the present application;

Fig. 3 is a schematic flowchart of a method for preprocessing initial starting data according to a specific embodiment of the present application;

Fig. 4(a) to Fig. 4(o) are schematic diagrams of a starting voltage and current waveform generated after a vehicle starts according to a specific embodiment of the present application; and

Fig. 5 is a block diagram of a structure of a cloud server according to an embodiment of the present application.

100-cloud server; 200-vehicle infotainment apparatus; 300-mobile terminal; 510-memory; 520-processor.

**Detailed Description of the Embodiments**

In order to make the objective, the technical solutions, and the advantages of the embodiments of the present application clearer, the technical solutions in the embodiments of the present application will be described clearly and completely below with reference to the drawings in the embodiments of the present application. It should be understood that specific implementation modes described herein are merely for describing and explaining the embodiments of the present application and not intended to limit the embodiments of the present application. All other embodiments obtained by a person of ordinary skill in the art based on the embodiments of the present application without creative efforts shall fall within the protection scope of the present application.

It is to be noted that if there is a directional indication (for example, upper, lower, left, right, front, or rear) in the embodiments of the present application, the directional indication is only for explaining a relative positional relationship, a motion status, and the like between components under a specific posture (as shown in the drawings), and if the specific posture changes, the directional indication changes accordingly.

In addition, if there are descriptions related to "first", "second", and the like in the embodiments of the present application, the descriptions related to "first", "second", and the like are merely for the illustrative purpose, and should not be construed as indicating or implying the relative importance thereof or implicitly indicating the number of technical features indicated. Therefore, a feature defined by "first" or "second" may explicitly or implicitly include at least one such feature. In addition, technical solutions in various embodiments may be combined with each other, provided that they can be implemented by a person of ordinary skill in the art. When a combination of the technical solutions is contradictory or cannot be implemented, it should be considered that such a combination of the technical solutions neither exists, nor falls within the protection scope claimed by the present application.

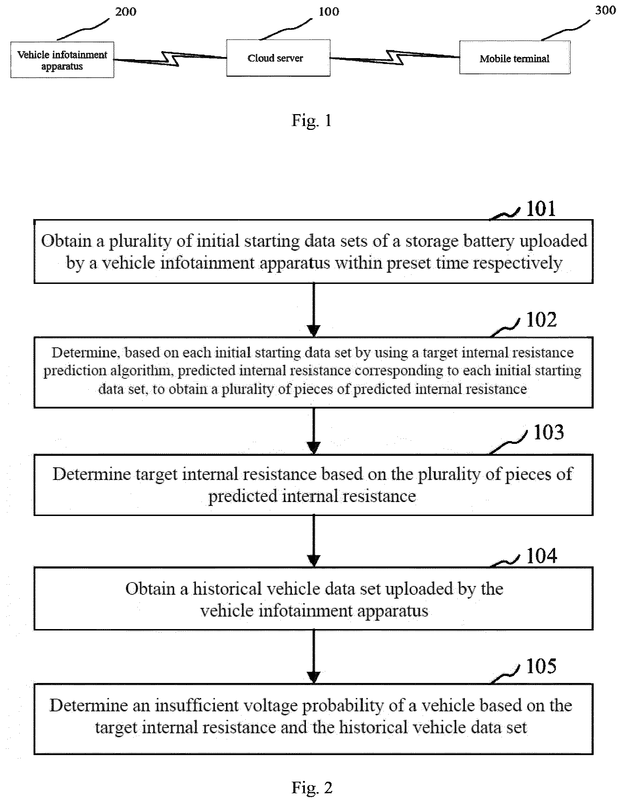

Fig. 1 is a schematic diagram of a structure of a system for predicting an insufficient voltage probability of a vehicle according to an embodiment of the present application. As shown in Fig. 1, an embodiment of the present application provides a system for predicting an insufficient voltage probability of a vehicle. The system may include a cloud server 100, a vehicle infotainment apparatus 200, and a mobile terminal 300. The cloud server 100 may communicate with the vehicle infotainment apparatus 200 and the mobile terminal 300 respectively, and is configured to receive data sent by the vehicle infotainment apparatus 200 to form cloud big data, predict an insufficient voltage probability of a vehicle based on the cloud big data, and further send a prediction result to the vehicle infotainment apparatus 200 and the mobile terminal 300, so that a user obtains an insufficient voltage status of the vehicle and responds in time. The vehicle infotainment apparatus 200 is configured to upload initial starting data generated during each start of the vehicle and historical data of the vehicle to the cloud server 100 in real time, to from the cloud big data. The mobile terminal 300 is configured to receive information sent by the cloud server 100, mainly the insufficient voltage probability of the vehicle, so that the user can obtain the insufficient voltage status of the vehicle in time.

Fig. 2 is a schematic flowchart of a method for predicting an insufficient voltage probability of a vehicle according to an embodiment of the present application. As shown in Fig. 2, an embodiment of the present application provides a method for predicting an insufficient voltage probability of a vehicle. The method is applied to a cloud server. The cloud server communicates with a vehicle infotainment apparatus. The method includes the following steps.

In step 101, a plurality of initial starting data sets of a storage battery uploaded by the vehicle infotainment apparatus within preset time are obtained respectively.

In step 102, predicted internal resistance corresponding to each initial starting data set is determined based on each initial starting data set by using a target internal resistance prediction algorithm, to obtain a plurality of pieces of predicted internal resistance.

In step 103, target internal resistance is determined based on the plurality of pieces of predicted internal resistance.

In step 104, a historical vehicle data set uploaded by the vehicle infotainment apparatus is obtained.

In step 105, an insufficient voltage probability of a vehicle is determined based on the target internal resistance and the historical vehicle data set.

The method for predicting an insufficient voltage probability of a vehicle in this embodiment of the present application may be applied to the cloud server. The cloud server may communicate with vehicle infotainment apparatuses of a plurality of vehicles respectively. In this embodiment of the present application, the cloud server communicates with the vehicle infotainment apparatus, so that the cloud server may obtain the initial starting data set of the storage battery uploaded by the vehicle infotainment apparatus. For a vehicle, a vehicle infotainment apparatus corresponding to the vehicle may upload, to the cloud server, an initial starting data set of a storage battery generated during each start of the vehicle. The initial starting data set is a set of a plurality of pieces of initial starting data of the storage battery generated during a specific start of the vehicle. The initial starting data set may include the plurality of pieces of initial starting data. The vehicle infotainment apparatus may set collection duration and a collection cycle based on an actual situation. For example, the vehicle infotainment apparatus may collect initial starting data generated within five minutes after the vehicle starts, and the collection cycle is 1 second. In this case, the initial starting data set includes 300 pieces of initial starting data. The initial starting data set may include initial starting voltage data, initial starting current data, an initial state of charge value, and initial temperature data.

In an example, the vehicle infotainment apparatus may include the storage battery, a storage battery sensor, a body control module, and a vehicle infotainment. The body control module may communicate with the storage battery sensor and the vehicle infotainment respectively. The vehicle infotainment may further communicate with the cloud server. Specifically, the storage battery sensor may be configured to collect a starting signal of the storage battery generated when the vehicle starts, and send the starting signal to the body control module. The body control module may convert the starting signal of the storage battery into initial starting data through data conversion, and control the initial starting data to the vehicle infotainment. After receiving the initial starting data, the vehicle infotainment may upload the initial starting signal to a cloud through a big data uploading channel, to form a cloud database to provide a data basis for subsequent calculation.

In research on an aging status of a storage battery, a parameter directly related to aging life is internal resistance of the battery. The internal resistance of the battery is one of the most important parameters of the battery as well as an important indicator characterizing remaining power of the battery and a health status of the battery, and reflects a difficulty level of transport of ions and electrons inside the battery between a positive electrode and a negative electrode during chemical reaction. Experimental data shows that with the increase of the number of charge and discharge cycles of the battery, the service life of the storage battery gradually decreases, and the internal resistance of the storage battery generally increases, so that a change in the service life of the storage battery may be characterized by a change in the internal resistance of the storage battery. Therefore, this embodiment of the present application proposes the method for predicting an insufficient voltage probability of a vehicle. Internal resistance prediction is performed on the storage battery to determine an aging status of the storage battery to further determine the insufficient voltage probability of the vehicle.

It is to be noted that a method for predicting the internal resistance of the storage battery in this embodiment of the present application is a model and data-based hybrid prediction method. In a model-based method, an algorithm model is constructed based on a physical characteristic of the storage battery, and then a voltage, a current, a state of charge, and a starting pulled-down voltage value of the storage battery are used as input values of the model to calculate an internal resistance value of the storage battery. In the model-based method, corresponding adjustment may be performed for characteristics of different types of storage batteries and different data representations, so that an application range is wide. In a data-based method, the internal resistance of the storage battery is predicted mainly through artificial intelligence and machine learning. The data-based method has an advantage of high accuracy. A disadvantage of the data-based method is that various experiments need to be performed on different storage batteries to generate a large amount of test data, training and data annotation need to be performed for a long time with a test data set to achieve desired effects, and this process usually takes a long time and needs a quite large data flow. At present, internal resistance prediction accuracy achieved by the data-based method is determined by training and tests that are performed based on a public and general data set, accuracy that can be achieved by the training and the tests cannot be copied to actual mass production projects, and simulation results and experimental results are not described in many projects. Therefore, predicting the internal resistance of the storage battery by using the model and data-based hybrid prediction method in this embodiment of the present application combines the advantages of the model-based method and the data-based method, and also helps create value quickly.

In this embodiment of the present application, the cloud server may predict the internal resistance of the storage battery based on the cloud big data. Specifically, to improve accuracy of a prediction result, the cloud server may first obtain the plurality of initial starting data sets of the storage battery uploaded by the vehicle infotainment apparatus within the preset time, then determine, by using the target internal resistance prediction algorithm, the predicted internal resistance corresponding to each initial starting data set, to obtain the plurality of pieces of predicted internal resistance, and further determine the target internal resistance based on the plurality of pieces of predicted internal resistance. The target internal resistance is a current internal resistance value of the storage battery corresponding to a current start of the vehicle. The preset time is a specified number of recent days during the current start of the vehicle. A numerical value of the preset time may be set as actually required. For example, the preset time may be recent seven days. In this case, the target internal resistance of the storage battery may be determined based on an initial starting data set of the storage battery during a first start of the vehicle on each of the recent seven days. If there is data corresponding to seven first starts of the vehicle in the seven days, seven initial starting data sets may be obtained, internal resistance prediction is performed on the seven initial starting data sets respectively to obtain at most seven pieces of predicted internal resistance, and the target internal resistance is further determined based on the plurality of pieces of predicted internal resistance.

In an example, internal resistance threshold screening may be performed on the plurality of pieces of predicted internal resistance to determine the target internal resistance of the storage battery. For example, predicted internal resistance corresponding to a specified number of starting moments at which a state of charge is maximum within the preset time may be screened. An internal resistance screening range is first set to [0.003 Q, 0.006 Q], that is, a normal internal resistance value result needs to be within [3 mΩ, 6 mΩ]. States of charge at all starting moments within the preset time and corresponding predicted internal resistance may further be stored as a two-column data table. The states of charge are arranged in descending order. For example, the specified number of starting moments is 5. In this case, five pieces of predicted internal resistance corresponding to the first five maximum states of charge are taken, and a mid-value of the five pieces of predicted internal resistance is used as current target internal resistance of the storage battery. In this way, data contingency can be prevented, and the accuracy of the prediction result can be improved.

In this embodiment of the present application, to feed back an aging status of the storage battery to the user in time to enable the user to perform a corresponding operation and improve user experience in using the vehicle, the cloud server may determine the insufficient voltage probability of the vehicle based on the target internal resistance of the storage battery corresponding to the current start of the vehicle and historical vehicle data. In an example, the historical vehicle data may include a historical warning record for an abnormality of the vehicle, a number of times the vehicle fails to start, a number of times the vehicle is parked for a preset number of days, a vehicle using habit record of the user, and an average battery power record. In this way, an insufficient voltage status of the vehicle may be output as a specific numerical value, so that the user can learn about the insufficient voltage status of the vehicle more directly and further respond in time. This helps improve user experience in using the vehicle.

According to the foregoing technical solution, the plurality of initial starting data sets of the storage battery uploaded by the vehicle infotainment apparatus within the preset time are first obtained respectively. Then, the predicted internal resistance corresponding to each initial starting data set is determined based on each initial starting data set by using the target internal resistance prediction algorithm, to obtain the plurality of pieces of predicted internal resistance. The target internal resistance is further determined based on the plurality of pieces of predicted internal resistance. Then, the historical vehicle data set uploaded by the vehicle infotainment apparatus is obtained. Finally, the insufficient voltage probability of the vehicle is determined based on the target internal resistance and the historical vehicle data set. In this way, internal resistance prediction is performed based on the cloud big data, the prediction result can be calibrated, and the insufficient voltage probability of the vehicle is determined by considering a plurality of influencing factors and combining the historical vehicle data. This helps improve accuracy of a calculation result.

In this embodiment of the present application, the operation in step 102 that predicted internal resistance corresponding to each initial starting data set is determined based on each initial starting data set by using a target internal resistance prediction algorithm may include the following operations:

for any initial starting data set, the any initial starting data set is preprocessed to obtain a target starting data set;

an initial internal resistance prediction algorithm is obtained;

algorithm conversion is performed on the initial internal resistance prediction algorithm to obtain the target internal resistance prediction algorithm; and

the target starting data set is run by using the target internal resistance prediction algorithm, to obtain predicted internal resistance corresponding to the any initial starting data set.

The target starting data set includes:
starting voltage data, starting current data, a state of charge value, and temperature data.

In this embodiment of the present application, to determine predicted internal resistance of the storage battery corresponding to any start of the vehicle, the cloud server may determine, by using the internal resistance prediction algorithm based on an initial starting data set of the storage battery received during this start of the vehicle, internal resistance of the storage battery corresponding to this start of the vehicle. Specifically, the cloud server may first obtain the initial internal resistance prediction algorithm, and perform algorithm conversion processing on the initial internal resistance prediction algorithm to obtain the target internal resistance prediction algorithm executable by the cloud server. The target internal resistance prediction algorithm is an internal resistance prediction algorithm executable by the cloud server. In a specific embodiment, algorithm conversion processing is first performed to convert a Python single-machine algorithm into a spark program executable by a cloud cluster, that is, a data input and output mode is modified. Then, a resource parameter of the cloud cluster is configured, including an executor data volume, a core number, a memory size, and the like. Finally, the cloud cluster is deployed and run, that is, input data is obtained from a data depository, and the program is run on a public cloud. In this way, a basic condition may be provided for subsequent internal resistance prediction. Further, to make the input data of the target internal resistance prediction algorithm up to standard, the cloud server may preprocess the initial starting data set to obtain the target starting data set. The target starting data set is a data set that satisfies a running standard of the target internal resistance prediction algorithm. Finally, the target starting data set is run by using the target internal resistance prediction algorithm, to obtain the predicted internal resistance corresponding to the initial starting data set.

In this embodiment of the present application, the target starting data set may include the starting voltage data, the starting current data, the state of charge value, and the temperature data. In an example, the target starting data set includes a plurality of pieces of starting data, and each piece of starting data includes specific numerical values corresponding to the four parameters: the starting voltage data, the starting current data, the state of charge value, and the temperature data. The starting voltage data is a voltage of the storage battery obtained when the vehicle starts. The starting current data is a current of the storage battery obtained when the vehicle starts. The state of charge is a ratio of a remaining capacity of the storage battery to a capacity of the storage battery in a fully charged state. The temperature data is a temperature value corresponding to a temperature signal of the storage battery obtained when the vehicle starts. In an example, the target starting data set may further include a starting pulled-down voltage value of the storage battery obtained when the vehicle starts. Therefore, the internal resistance of the storage battery during the start of the vehicle may be predicted based on the above parameters.

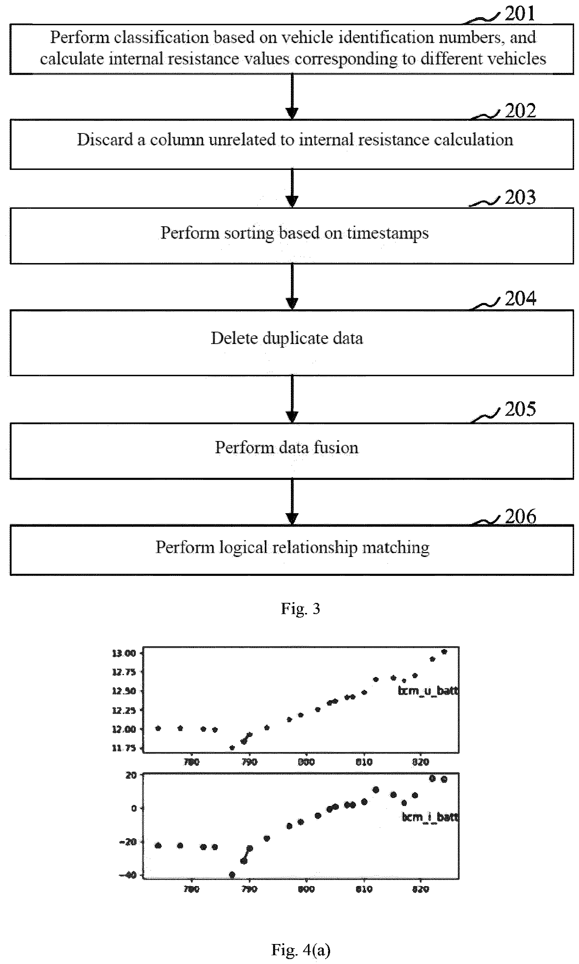

Fig. 3 is a schematic flowchart of a method for preprocessing the initial starting data according to a specific embodiment of the present application. As shown in Fig. 3, in a specific embodiment, since the cloud server may communicate with the vehicle infotainment apparatuses of the plurality of vehicles at the same time, preprocessing of the initial starting data may include the following steps.

In step 201, classification is performed based on vehicle identification numbers, and internal resistance values corresponding to different vehicles is calculated.

In step 202, a column unrelated to internal resistance calculation is discarded.

In step 203, sorting is performed based on timestamps.

In step 204, duplicate data is deleted.

Specifically, a data row corresponding to a same timestamp and a same can_id may be discarded.

In step 205, data fusion is performed.

Specifically, deleting the duplicate data may disorder data indexes. Therefore, the indexes may be first reset, and then data corresponding to a same timestamp and different can sources is fused into a row.

In step 206, logical relationship matching is performed.

Specifically, "bcm_soc" representing the state of charge value of the storage battery has a subordinate field "bcm_soc_state", and when bcm_soc_state is 1 or 2, the state of charge value is valid.

"bcm_i_batt" representing the starting current data of the storage battery also has a subordinate field "bcm_i_range". "bcm_i_batt" is not real current data of the storage battery, and needs to be converted from the subordinate field "bcm_i_range".

When bcm_i_range=3, a current value corresponding to the starting current data of the storage battery is invalid.

When $bcm\_i\_batt>0$, and $bcm\_i\_range=0$, $bcm\_i\_batt=(bcm\_i\_batt-32768)\times2^{-10}$.

When $bcm\_i\_batt>0$, and $bcm\_i\_range=1$, $bcm\_i\_batt=(bcm\_i\_batt-32768)\times2^{-7}$.

When $bcm\_i\_batt>0$, and $bcm\_i\_range=2$, $bcm\_i\_batt=(bcm\_i\_batt-32768)\times2^{-4}$.

Therefore, according to the foregoing technical solution, the initial starting data of the storage battery is preprocessed to finally obtain target starting data, to provide a data basis for subsequent prediction of the internal resistance of the storage battery. In addition, some undesired data is rejected, which is conducive to improvement of computational efficiency.

In this embodiment of the present application, the operation that the target starting data set is run by using the target internal resistance prediction algorithm, to obtain predicted internal resistance corresponding to the any initial starting data set may include the following operations:

whether the target starting data set satisfies a specified condition is determined;

when the target starting data set satisfies the specified condition, a starting voltage distribution map and a starting current distribution map are obtained based on the starting voltage data and the starting current data respectively;

whether the target starting data set is a valid starting data set is determined based on the starting voltage distribution map and the starting current distribution map; and

when the target starting data set is a valid starting data set, the predicted internal resistance is determined based on the starting voltage distribution map and the starting current distribution map.

The specified condition is that first obtained temperature data in the target starting data set satisfies a preset temperature range and a first obtained state of charge value in the target starting data set is greater than a specified state of charge value.

In this embodiment of the present application, to determine the internal resistance value of the storage battery during the start of the vehicle, the cloud server may run a target starting data set of the storage battery corresponding to any start of the vehicle by using the target internal resistance prediction algorithm, to obtain predicted internal resistance of the storage battery corresponding to the any start of the vehicle. The internal resistance of the storage battery is usually affected greatly by the temperature and the state of charge. To accurately predict the internal resistance of the storage battery, whether the target starting data set satisfies the specified condition needs to be first determined, to determine whether the target starting data set is available data. Specifically, the corresponding temperature data and state of charge of the storage battery within a period of time after the vehicle starts substantially remain unchanged. Therefore, for a target starting data set corresponding to any start of the vehicle, the specified condition is that first obtained temperature data in the starting data set satisfies the preset temperature range and a first obtained state of charge value in the starting data set is greater than the specified state of charge value. The preset temperature range is a temperature limiting condition that needs to be satisfied when the target starting data set is available data. The specified state of charge value is a threshold condition that the state of charge of the storage battery needs to satisfy.

In this embodiment of the present application, whether the first obtained temperature data in the target starting data set satisfies the preset temperature range may be first determined. When the temperature data does not satisfy the preset temperature range, it is determined that the target starting data set corresponding to this start of the vehicle is unavailable data, the target starting data set is ignored, and the internal resistance of the storage battery corresponding to the target starting data set is not predictively solved. When the temperature data satisfies the preset temperature range, the state of charge value is determined. In an example, the preset temperature range is usually a normal temperature range, and a specific numerical value of the preset temperature range is determined based on a specific situation. For example, a normal temperature in an experiment is defined to 25°C ($\pm2$°C). In this embodiment of the present application, to increase the amount of available data obtained by the cloud server, an ambient temperature range may be extended by $\pm$ 10°C. In this case, the preset temperature range is adjusted to 10°C to 35°C. In this temperature range, a chemical feature of the storage battery does not change greatly.

In this embodiment of the present application, when the temperature data satisfies the preset temperature range, whether the first obtained state of charge value in the target starting data set is greater than the specified state of charge value is determined. The specified state of charge value may be set based on an actual situation. For example, the specified state of charge value may be 60%. It is to be noted that for the storage battery, under a same precondition, if a status of the storage battery is more stable, the corresponding state of charge value is higher, and the prediction result of internal resistance prediction is more accurate.

In an example, when the state of charge value is less than or equal to the specified state of charge value, it is determined that the target starting data set is unavailable data, and the internal resistance of the storage battery corresponding to the target starting data set is not predictively solved. In another example, when the state of charge value is greater than the specified state of charge value, whether the target starting data set is a valid starting data set is further determined. Specifically, the cloud server may obtain the starting voltage distribution map and the starting current distribution map based on a plurality of pieces of starting voltage data and starting current data in the target starting data set. For example, 100 pieces of non-null data in the target starting data set may be obtained, and the starting voltage distribution map and the starting current distribution map are obtained based on starting voltage data and starting current data in the 100 pieces of non-null data.

Further, whether the target starting data set is a valid starting data set is determined based on the starting voltage distribution map and the starting current distribution map. When the target starting data set is a valid starting data set, the predicted internal resistance is determined based on the starting voltage distribution map and the starting current distribution map. In this way, a determining precondition is set in consideration of impact of an environmental factor and the characteristic of the storage battery, to eliminate impact of the unavailable data on a final result, and the internal resistance of the storage battery is further predicted. This helps improve the computational efficiency and the accuracy of the prediction result.

In this embodiment of the present application, the operation that whether the target starting data set is a valid starting data set is determined based on the starting voltage distribution map and the starting current distribution map may include the following operations:

a voltage and current waveform generated after the vehicle starts is analyzed based on the starting voltage distribution map and the starting current distribution map; and

when the voltage and current waveform satisfies a first feature, it is determined that the target starting data set is a valid starting data set; or

when the voltage and current waveform satisfies a second feature, it is determined that the target starting data set is an invalid starting data set.

In this embodiment of the present application, to determine the predicted internal resistance corresponding to the target starting data set, the cloud server may first determine whether the target starting data set is a valid starting data set, that is, whether a data distribution of the target starting data set conforms to a rule. In this embodiment of the present application, waveform analysis is performed on a starting voltage and a starting current of the storage battery during the start of the vehicle, to determine whether the target starting data set corresponding to this start is a valid starting data set. Specifically, the cloud server may obtain, based on the target starting data set, the starting voltage distribution map and the starting current distribution map that correspond to this start, further perform voltage and current waveform analysis on the starting voltage distribution map and the starting current distribution map, and determine a voltage and current distribution after this start based on the corresponding voltage and current waveform, to determine whether the target starting data set corresponding to this start is a valid starting data set.

In this embodiment of the present application, the first feature is a feature that conforms to a voltage and current change rule corresponding to a valid starting data set, and the second feature is a feature that conforms to a voltage and current change rule corresponding to an invalid starting data set. When the voltage and current waveform satisfies the first feature, it may be determined that the target starting data set is a valid starting data set, and the internal resistance of the storage battery after this start is further predictively calculated. When the voltage and current waveform satisfies the second feature, it may be determined that the target starting data set is an invalid starting data set. In this case, the target starting data set is unsuitable for solving the internal resistance, the target starting data set is ignored, and internal resistance prediction is not performed for this start.

Fig. 4(a) to Fig. 4(o) are schematic diagrams of the starting voltage and current waveform generated after the vehicle starts according to a specific embodiment of the present application. In an example, the second feature may include the following two cases.

In a first case, after the vehicle starts, the voltage and the current remain steady within first specified time, and after the first specified time, the voltage and the current fluctuate and are finally unsteady. As shown in Fig. 4(a), the voltage and the current in this case do not conform to the voltage and current change rule after the start of the storage battery.

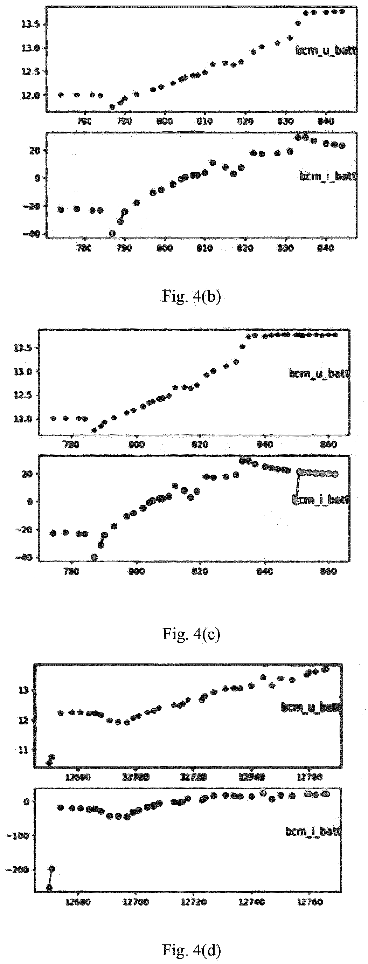

In a second case, after the vehicle starts, the voltage and the current remain steady within first specified time, and after the first specified time, the voltage and the current fluctuate and are finally steady. As shown in Fig. 4(b) and Fig. 4(c), the voltage and the current in this case do not conform to the voltage and current change rule after the start of the storage battery.

When the voltage and current waveform satisfies any one of the two cases of the second feature, it may be determined that the target starting data set corresponding to this start is an invalid starting data set.

In another example, the second feature may include the following three cases.

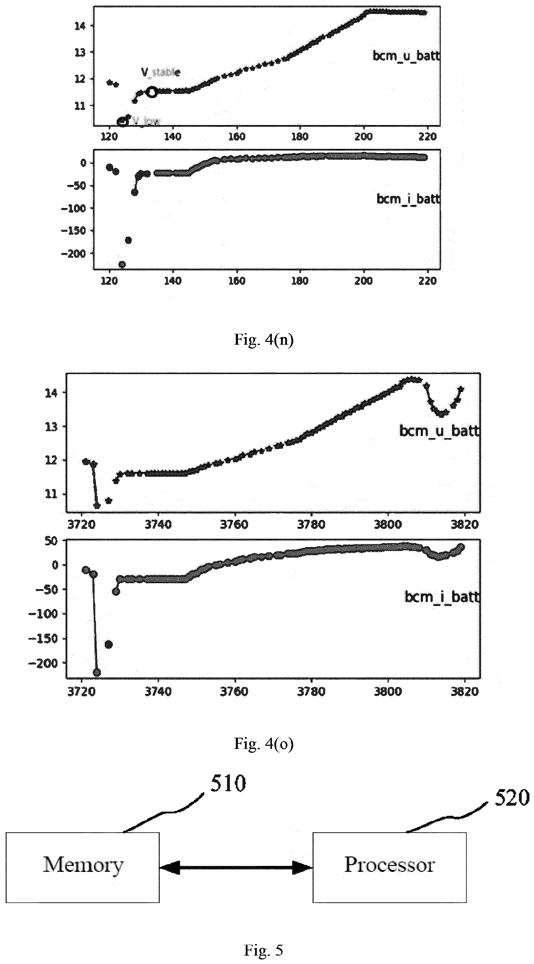

In a first case, after the vehicle starts, the voltage and the current remain steady within second specified time, and after the second specified time, the voltage and the current fluctuate and are finally unsteady. As shown in Fig. 4(n) and Fig. 4(o), the voltage and the current in this case conform to a general voltage and current change rule after the start of the storage battery, and are suitable for solving the internal resistance.

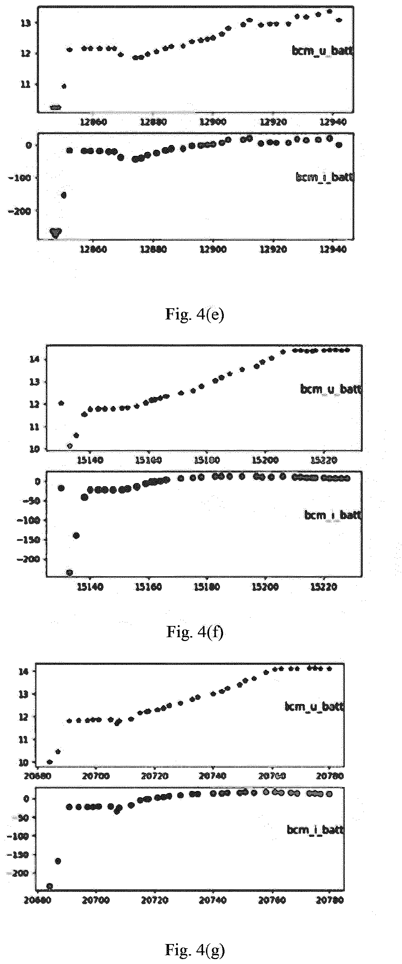

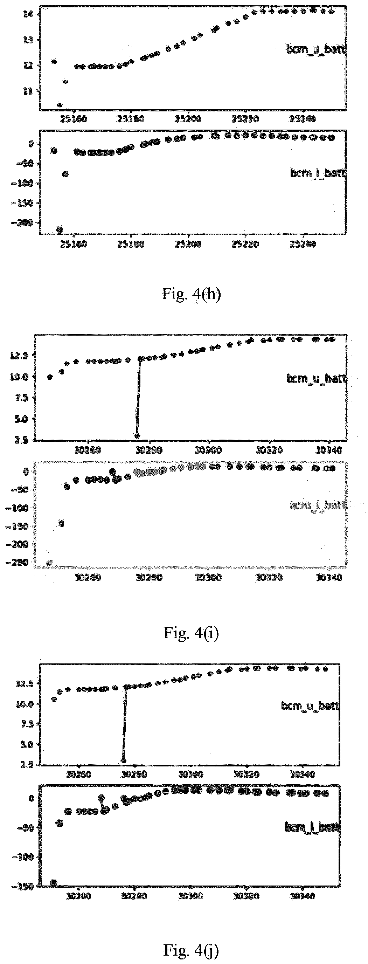

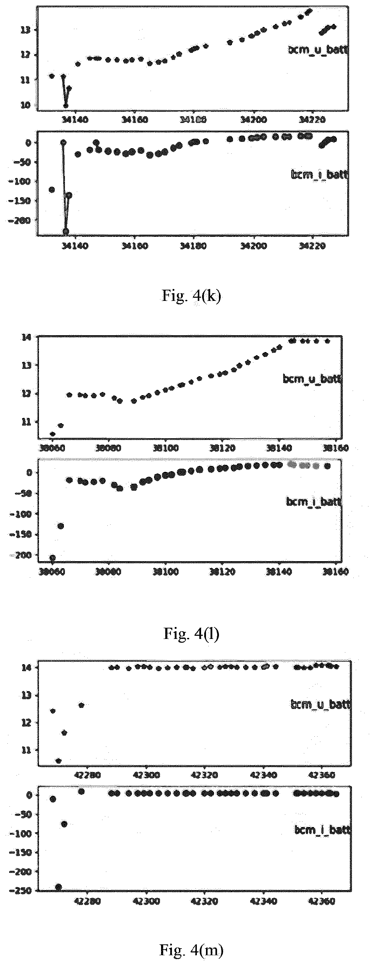

In a second case, after the vehicle starts, the voltage and the current rise monotonously, approximately follow a step distribution, and are finally steady. As shown in Fig. 4(d), Fig. 4(e), Fig. 4(g), Fig. 4(i), Fig. 4(j), and Fig. 4(l), the voltage and the current in this case present an ideal voltage and current distribution after the start of the storage battery, and are most suitable for solving the internal resistance.

In a third case, after the vehicle starts, the voltage and the current show a downward trend within second specified time, and after the second specified time, the voltage and the current rise monotonously, approximately follow a step distribution, and are finally steady. As shown in Fig. 4(f), Fig. 4(h), Fig. 4(k), and Fig. 4(m), the voltage and the current in this case conform to a general voltage and current distribution rule after the start of the storage battery, and are suitable for solving the internal resistance.

When the voltage and current waveform satisfies any one of the three cases of the second feature, it may be determined that the target data set corresponding to this start is a valid starting data set. The first specified time and the second specified time each may be a time range. For different types of storage batteries, the first specified time and the second specified time are both different. Specific numerical values of the first specified time and the second specified time may be measured based on an experiment. In addition, the first specified time is greater than the second specified time.

Therefore, determining whether the corresponding target starting data set is a valid starting data set based on the voltage and current distribution after the start of the vehicle may screen out a target starting data set suitable for solving the internal resistance for internal resistance prediction, which helps improve the accuracy of the prediction result.

In this embodiment of the present application, the operation that the predicted internal resistance is determined based on the target starting voltage distribution map and the starting current distribution map may include the following operations:

a voltage minimum and a steady-state voltage value that correspond to the target starting data set are determined based on the starting voltage distribution map;

a current minimum and a steady-state current value that correspond to the target starting data set are determined based on the starting current distribution map; and

the predicted internal resistance is determined based on the voltage minimum value, the steady-state voltage value, the current minimum, and the steady-state current value.

In this embodiment of the present application, after it is determined that the target starting data set is a valid starting data set, the predicted internal resistance corresponding to the target starting data set may be determined based on the starting voltage data and the starting current data in the target starting data set. Specifically, the cloud server may obtain the voltage minimum, the steady-state voltage value, the current minimum, and the steady-state current value of the storage battery in the starting voltage distribution map and the starting current distribution map that correspond to the target starting data set. Further, the predicted internal resistance is determined based on the voltage minimum value, the steady-state voltage value, the current minimum, and the steady-state current value. In an example, the predicted internal resistance may satisfy the following formula:

$$R_{now} = \frac{V\_low - V\_Stable}{I\_low - I\_Stable}$$

$R_{now}$ is the currently calculated predicted internal resistance corresponding to the target starting data set. V_low is the voltage minimum. V_Stable is the steady-state voltage value. I_low is the current minimum. I_Stable is the steady-state current value. In this way, determining the predicted internal resistance by using the minimums and the steady-state values of the voltage and the current of the storage battery during the start of the vehicle can improve the accuracy of the calculation result.

In this embodiment of the present application, the operation in step 105 that an insufficient voltage probability of a vehicle based on the target internal resistance and the historical vehicle data set may include the following operations:

whether the target internal resistance is greater than preset internal resistance is determined; and
when the target internal resistance is greater than the preset internal resistance, the insufficient voltage probability of the vehicle is determined based on the historical vehicle data set.

In this embodiment of the present application, to enable the user to directly obtain the insufficient voltage status of the vehicle, the insufficient voltage probability of the vehicle may be further determined based on the historical vehicle data after the target internal resistance of the storage battery is determined. Specifically, there is no insufficient voltage risk when the internal resistance of the storage battery is low. Therefore, the internal resistance of the storage battery may be used as a precondition for determining the insufficient voltage probability of the vehicle. Whether the target internal resistance obtained through internal resistance prediction is greater than the preset internal resistance is first determined. When the target internal resistance is greater than the preset internal resistance, the insufficient voltage probability of the vehicle is determined based on the historical vehicle data set. The preset internal resistance is an internal resistance limiting condition of the storage battery for determining whether there is an insufficient voltage risk for the vehicle. The preset internal resistance value is set based on different types of storage batteries and an actual situation. For example, when a normal internal resistance value of the storage battery is within [3 mS2, 6 mΩ], the preset internal resistance may be 4 mΩ. In this case, when the target internal resistance is within [3 mS2, 4 mΩ], there is no insufficient voltage risk for the vehicle, and the insufficient voltage probability of the vehicle does not need to be calculated, or the insufficient voltage probability of the vehicle is directly output as 0. When the target internal resistance is within (4 mΩ, 6 mΩ], there is an insufficient voltage risk for the vehicle, and the insufficient voltage probability of the vehicle may be determined based on the historical vehicle data. In this way, the calculation efficiency can be improved, and the calculation result is more accurate.

In an example, the historical vehicle data set may include five major categories: a historical warning record for an abnormality of the vehicle, a number of times the vehicle fails to start, a number of times the vehicle is parked for a preset number of days, a vehicle using habit record of the user, and an average battery power record. The cloud server may determine the insufficient voltage probability of the vehicle by combining the five major categories of historical vehicle data. Each category of historical vehicle data corresponds to a specified standard. A base value of the insufficient voltage probability of the vehicle is set to 0. When each category of historical vehicle data satisfies the corresponding specified standard, the insufficient voltage probability of the vehicle increases by 20%. The five major categories of historical vehicle data are determined respectively, to finally obtain a current insufficient voltage probability of the vehicle. For example, when two categories of historical data in the five major categories of historical data do not satisfy the corresponding specified standards, and the other three categories satisfy the corresponding specified standards, the insufficient voltage probability of the vehicle is 60%. In this way, the insufficient voltage status of the vehicle can be numeralized, so that the user can learn about the insufficient voltage status of the vehicle more directly. Determining the insufficient voltage probability of the vehicle based on the historical vehicle data set considers a plurality of influencing factors, so that the calculation result is more accurate, and user experience is improved.

It is to be noted that when the data of the cloud server does not satisfy the precondition for internal resistance prediction, the target internal resistance of the storage battery cannot be obtained. To be specific, when target starting data corresponding to each start of the vehicle within the preset time is unavailable data or invalid data, the current target internal resistance of the storage battery of the vehicle cannot be determined. In this case, the five major categories of historical vehicle data can be directly combined to obtain the insufficient voltage probability of the vehicle through comprehensive determining, so as to prevent contingency.

In this embodiment of the present application, the historical vehicle data set may include:
a historical warning record for an abnormality of the vehicle, a number of times the vehicle fails to start, a number of times the vehicle is parked for a preset number of days, a vehicle using habit record of the user, and an average battery power record.

Specifically, the historical warning record for the abnormality of the vehicle is used for representing whether the vehicle has a leakage problem, and data of the vehicle in a recent year may be queried through an insufficient voltage monitoring system to obtain leakage of the vehicle in the recent year. In this case, a specified standard corresponding to the historical warning record for the abnormality of the vehicle may be that the vehicle gives more than one abnormal leakage warning in a recent month.

The number of times the vehicle fails to start may be obtained by querying cloud data, mainly a historical number of times the corresponding vehicle has an insufficient voltage, for example, a problem that the vehicle fails to start due to use of electricity at an ON gear. A specified standard corresponding to the number of times the vehicle fails to start may be that the vehicle fails to be start at least once within a recent month.

The number of times the vehicle is parked for the preset number of days may be obtained by querying the cloud data. Duration of each parking course of the vehicle is queried to determine whether the vehicle is parked for a long time. The preset number of days is a specified value of the number of days in which the vehicle remains parked, and may be set based on a specific situation. For example, the preset number of days may be 10 days. In this case, a specified standard corresponding to the number of times the vehicle is parked for the preset number of days may be that the vehicle remains parked for at least 10 days at least once within a recent month.

The vehicle using habit record of the user is mainly a short-distance driving situation of the user per day. The number of times of short-distance driving of the user per day may be obtained by querying the cloud data. In this case, a specified standard corresponding to the vehicle using habit record of the user may be that the number of times the vehicle is used for not more than 10 minutes within a recent month is greater than or equal to 50% of the total number of vehicle using times within the recent month. In an example, vehicle using information of the user in a month may be statistically obtained first. The statistical information may include a total number of vehicle using times, a number of times the vehicle is used for more than 30 minutes, a number of times the vehicle is used for a time greater than 10 minutes and less than or equal to 30 minutes, and a number of times the vehicle is used for less than or equal to 10 minutes.

The average battery power record is average power of the vehicle per day, and a corresponding specified standard may be that the power remains lower than 50% within a recent month. It is to be noted that the specified standards corresponding to the above five major categories of historical vehicle data respectively may be set based on an actual situation of the vehicle, and the above is merely an example for description. In this way, calculating the insufficient voltage probability of the vehicle by considering a plurality of influencing factors and combining the above five major categories of historical vehicle data can improve the accuracy of the calculation result.

In this embodiment of the present application, the cloud server further communicates with a mobile terminal. The method for predicting an insufficient voltage probability of a vehicle may further include the following operation:
when the insufficient voltage probability is greater than a warning threshold, a prompt signal is sent to the mobile terminal and the vehicle infotainment apparatus.

Specifically, to enable the user to perform a corresponding operation in time when there is an insufficient voltage risk for the vehicle, the warning threshold may be set. The warning threshold is a corresponding threshold condition corresponding to the insufficient voltage probability for determining whether there is an insufficient voltage risk for the vehicle. When the insufficient voltage probability of the vehicle is greater than the warning threshold, the cloud server may send the prompt signal to the mobile terminal and further to the vehicle infotainment apparatus. The mobile terminal may be a mobile APP used by the user. The vehicle infotainment apparatus receives prompt information mainly through an instrument. In an example, to prevent reduction of user experience caused by frequent prompting, a warning withdrawal threshold may further be set to determine whether a warning may be withdrawn. In this case, when the insufficient voltage probability of the vehicle is greater than the warning threshold, the prompt signal is sent to prompt the user, and the user may operate the vehicle based on the prompt information. When the insufficient voltage probability of the vehicle is less than the warning withdrawal threshold, the prompt signal is stopped to be sent. For example, when the insufficient voltage probability reaches 60%, the prompt signal is sent. When the insufficient voltage probability is lower than 40%, the warning is withdrawn. In this way, the user can be prompted that there is an insufficient voltage risk for the vehicle, so that the user can check the vehicle in advance to eliminate the risk.

Fig. 5 is a block diagram of a structure of a cloud server according to an embodiment of the present application. As shown in Fig. 5, an embodiment of the present application provides a cloud server, which may include:

a memory 510, configured to store instructions; and

a processor 520, configured to invoke the instructions from the memory 510 and capable of implementing, when executing the instructions, the foregoing method for predicting an insufficient voltage probability of a vehicle.

Specifically, in this embodiment of the present application, the processor 520 may be configured to:

obtain a plurality of initial starting data sets of a storage battery uploaded by the vehicle infotainment apparatus within preset time respectively;

determine, based on each initial starting data set by using a target internal resistance prediction algorithm, predicted internal resistance corresponding to each initial starting data set, to obtain a plurality of pieces of predicted internal resistance;

determine target internal resistance based on the plurality of pieces of predicted internal resistance;

obtain a historical vehicle data set uploaded by the vehicle infotainment apparatus; and

determine an insufficient voltage probability of a vehicle based on the target internal resistance and the historical vehicle data set.

Further, the processor 520 may further be configured to:

for any initial starting data set, preprocess the any initial starting data set to obtain a target starting data set;

obtain an initial internal resistance prediction algorithm;

perform algorithm conversion on the initial internal resistance prediction algorithm to obtain the target internal resistance prediction algorithm; and

run the target starting data set by using the target internal resistance prediction algorithm, to obtain predicted internal resistance corresponding to the any initial starting data set.

The target starting data set includes:
starting voltage data, starting current data, a state of charge value, and temperature data.

Further, the processor 520 may further be configured to:

determine whether the target starting data set satisfies a specified condition;

when the target starting data set satisfies the specified condition, obtain a starting voltage distribution map and a starting current distribution map based on the starting voltage data and the starting current data respectively;

determine, based on the starting voltage distribution map and the starting current distribution map, whether the target starting data set is a valid starting data set; and

when the target starting data set is a valid starting data set, determine the predicted internal resistance based on the starting voltage distribution map and the starting current distribution map.

The specified condition is that first obtained temperature data in the target starting data set satisfies a preset temperature range and a first obtained state of charge value in the target starting data set is greater than a specified state of charge value.

Further, the processor 520 may further be configured to:

analyze, based on the starting voltage distribution map and the starting current distribution map, a voltage and current waveform generated after the vehicle starts; and

when the voltage and current waveform satisfies a first feature, determine that the target starting data set is a valid starting data set; or

when the voltage and current waveform satisfies a second feature, determine that the target starting data set is an invalid starting data set.

Further, the processor 520 may further be configured to:

determine, based on the starting voltage distribution map, a voltage minimum and a steady-state voltage value that correspond to the target starting data set;

determine, based on the starting current distribution map, a current minimum and a steady-state current value that correspond to the target starting data set; and

determine the predicted internal resistance based on the voltage minimum value, the steady-state voltage value, the current minimum, and the steady-state current value.

Further, the processor 520 may further be configured to:

determine whether the target internal resistance is greater than preset internal resistance; and

when the target internal resistance is greater than the preset internal resistance, determine the insufficient voltage probability of the vehicle based on the historical vehicle data set.

In this embodiment of the present application, the historical vehicle data set includes:
a historical warning record for an abnormality of the vehicle, a number of times the vehicle fails to start, a number of times the vehicle is parked for a preset number of days, a vehicle using habit record of a user, and an average battery power record.

Further, the processor 520 may further be configured to:
when the insufficient voltage probability is greater than a warning threshold, send a prompt signal to the mobile terminal and the vehicle infotainment apparatus.

According to the foregoing technical solution, the plurality of initial starting data sets of the storage battery uploaded by the vehicle infotainment apparatus within the preset time are first obtained respectively. Then, the predicted internal resistance corresponding to each initial starting data set is determined based on each initial starting data set by using the target internal resistance prediction algorithm, to obtain the plurality of pieces of predicted internal resistance. The target internal resistance is further determined based on the plurality of pieces of predicted internal resistance. Then, the historical vehicle data set uploaded by the vehicle infotainment apparatus is obtained. Finally, the insufficient voltage probability of the vehicle is determined based on the target internal resistance and the historical vehicle data set. In this way, internal resistance prediction is performed based on cloud big data, a prediction result can be calibrated, and the insufficient voltage probability of the vehicle is determined by considering a plurality of influencing factors and combining historical vehicle data. This helps improve accuracy of a calculation result.

As shown in Fig. 1, an embodiment of the present application further provides a system for predicting an insufficient voltage probability of a vehicle. The system includes:

the foregoing cloud server 100; and

a vehicle infotainment apparatus 200, communicating with the cloud server 100 and configured to upload a plurality of initial starting data sets of a storage battery to the cloud server 100 and receive a prompt signal sent by the cloud server 100.

In this embodiment of the present application, the system for predicting an insufficient voltage probability of a vehicle may include the cloud server 100 and the vehicle infotainment apparatus 200. The vehicle infotainment apparatus 200 may communicate with the cloud server 100. The vehicle infotainment apparatus 200 may upload data of the vehicle to the cloud server 100 in real time, to from cloud big data. The cloud server 100 may predict an insufficient voltage probability of a vehicle based on the cloud big data, and further send a prediction result to the vehicle infotainment apparatus 200, so that a user can learn about the insufficient voltage status of the vehicle in time and respond in advance. Therefore, user experience in using the vehicle is improved.

As shown in Fig. 1, in this embodiment of the present application, the system for predicting an insufficient voltage probability of a vehicle further includes:
a mobile terminal 300, communicating with the cloud server 100 and configured to receive the prompt signal sent by the cloud server 100.

Specifically, to enable the user to receive information about the insufficient voltage probability of the vehicle in time, the system for predicting an insufficient voltage probability of a vehicle may further include the mobile terminal 300. The mobile terminal 300 may communicate with the cloud server 100, may be a mobile APP used by the user, and is configured to receive the prompt signal sent by the cloud server 100. This helps the user learn about an insufficient voltage status of the user in time and improve user experience in using the vehicle.

An embodiment of the present application further provides a machine-readable storage medium. Instructions are stored on the machine-readable storage medium. The instructions are used for enabling a machine to perform the foregoing method for predicting an insufficient voltage probability of a vehicle.

A person skilled in the art should know that the embodiment of the present application may be provided as a method, a system, or a computer program product. Therefore, the present application may use a form of hardware only embodiments, software only embodiments, or embodiments with a combination of software and hardware. In addition, the present application may use a form of a computer program product that is implemented on one or more computer-usable storage media (including but not limited to a disk memory, a CD-ROM, and an optical memory) that include computer-usable program code.

The present application is described with reference to flowcharts and/or block diagrams of the method, the device (system), and the computer program product according to the embodiments of the present application. It should be understood that computer program instructions may be used to implement each process and/or each block in the flowcharts and/or the block diagrams, or a combination of a process and/or a block in the flowcharts and/or the block diagrams. These computer program instructions may be provided to a general-purpose computer, a special-purpose computer, an embedded processor, or a processor of another programmable data processing device to generate a machine, so that the instructions executed by the computer or the processor of the another programmable data processing device generate an apparatus for implementing a specified function in one or more processes in the flowcharts and/or in one or more blocks in the block diagrams.

These computer program instructions may alternatively be stored in a computer-readable memory capable of instructing the computer or another programmable data processing device to work in a specific manner, so that the instructions stored in the computer-readable memory generate an artifact that includes an instruction apparatus. The instruction apparatus implements a specified function in one or more processes in the flowcharts and/or in one or more blocks in the block diagrams.

The computer program instructions may alternatively be loaded onto the computer or another programmable data processing device, so that a series of operating steps are performed on the computer or the another programmable device, to generate computer-implemented processing. Therefore, the instructions executed on the computer or the another programmable device provide steps for implementing a specific function in one or more processes in the flowcharts and/or in one or more blocks in the block diagrams.

In a typical configuration, the computing device includes one or more processors (CPU), an input/output interface, a network interface, and a memory.

The memory may include a form of a non-permanent memory such as a random access memory (RAM) and/or a non-volatile memory such as a read-only memory (ROM) or a flash memory (flash RAM) in a computer-readable medium. The memory is an example of the computer-readable medium.

The computer-readable medium includes permanent and non-permanent, removable and non-removable media, and information storage may be implemented by any method or technology. The information may be computer-readable instructions, a data structure, a program module, or other data. Examples of the computer storage medium include but are not limited to a phase-change memory (PRAM), a static random access memory (SRAM), a dynamic random access memory (DRAM), other types of random access memories (RAMs), a read-only memory (ROM), an electrically erasable programmable read-only memory (EEPROM), a flash memory or other memory technologies, a compact disc read-only memory (CD-ROM), a digital versatile disc (DVD) or other optical storage, a magnetic cassette, a magnetic tape, a magnetic disk storage or other magnetic storage devices, or any other non-transmission media, which can be used to store information accessible by the computing device. As defined in this specification, the computer-readable medium does not include transitory computer-readable media (transitory media), such as a modulated data signal and carrier.

It is also to be noted that the terms "include", "contain", or any of their variants is intended to cover a non-exclusive inclusion, so that a process, a method, a commodity, or a device including a set of elements not only includes those elements but also includes other elements that are not expressly listed, or further includes elements inherent to such process, method, commodity, or device. With no more restrictions, an element defined by the statement "including a/an..." does not exclude existence of the same other elements in a process, method, commodity, or device including the element.

The above is only the embodiment of the present application and not intended to limit the present application. A person skilled in the art may make various modifications and variations to the present application. Any modifications, equivalent replacements, improvements, and the like made within the spirit and principle of the present application shall fall within the scope of protection of the claims of the present application.

## Claims

1. A method for predicting an insufficient voltage probability of a vehicle, wherein the method is applied to a cloud server, the cloud server communicates with a vehicle infotainment apparatus, and the method comprises:

   obtaining a plurality of initial starting data sets of a storage battery uploaded by the vehicle infotainment apparatus within preset time respectively;

   determining, based on each initial starting data set by using a target internal resistance prediction algorithm, predicted internal resistance corresponding to each initial starting data set, to obtain a plurality of pieces of predicted internal resistance;

   determining target internal resistance based on the plurality of pieces of predicted internal resistance;

   obtaining a historical vehicle data set uploaded by the vehicle infotainment apparatus; and

   determining an insufficient voltage probability of a vehicle based on the target internal resistance and the historical vehicle data set.

2. The method for predicting an insufficient voltage probability of a vehicle according to claim 1, wherein the determining, based on each initial starting data set by using a target internal resistance prediction algorithm, predicted internal resistance corresponding to each initial starting data set comprises:

   for any initial starting data set, preprocessing the any initial starting data set to obtain a target starting data set;

obtaining an initial internal resistance prediction algorithm;

performing algorithm conversion on the initial internal resistance prediction algorithm to obtain the target internal resistance prediction algorithm; and

running the target starting data set by using the target internal resistance prediction algorithm, to obtain predicted internal resistance corresponding to the any initial starting data set, wherein

the target starting data set comprises:

   starting voltage data, starting current data, a state of charge value, and temperature data.

3. The method for predicting an insufficient voltage probability of a vehicle according to claim 2, wherein the running the target starting data set by using the target internal resistance prediction algorithm, to obtain predicted internal resistance corresponding to the any initial starting data set comprises:

   determining whether the target starting data set satisfies a specified condition;

   when the target starting data set satisfies the specified condition, obtaining a starting voltage distribution map and a starting current distribution map based on the starting voltage data and the starting current data respectively;

   determining, based on the starting voltage distribution map and the starting current distribution map, whether the target starting data set is a valid starting data set; and

   when the target starting data set is a valid starting data set, determining the predicted internal resistance based on the starting voltage distribution map and the starting current distribution map, wherein

   the specified condition is that first obtained temperature data in the target starting data set satisfies a preset temperature range and a first obtained state of charge value in the target starting data set is greater than a specified state of charge value.

4. The method for predicting an insufficient voltage probability of a vehicle according to claim 3, wherein the determining, based on the starting voltage distribution map and the starting current distribution map, whether the target starting data set is a valid starting data set comprises:

   analyzing, based on the starting voltage distribution map and the starting current distribution map, a voltage and current waveform generated after the vehicle starts; and

when the voltage and current waveform satisfies a first feature, determining that the target starting data set is a valid starting data set; or

when the voltage and current waveform satisfies a second feature, determining that the target starting data set is an invalid starting data set.

5. The method for predicting an insufficient voltage probability of a vehicle according to claim 3, wherein the determining the predicted internal resistance based on the starting voltage distribution map and the starting current distribution map comprises:

determining, based on the starting voltage distribution map, a voltage minimum and a steady-state voltage value that correspond to the target starting data set;

determining, based on the starting current distribution map, a current minimum and a steady-state current value that correspond to the target starting data set; and

determining the predicted internal resistance based on the voltage minimum value, the steady-state voltage value, the current minimum, and the steady-state current value.

6. The method for predicting an insufficient voltage probability of a vehicle according to claim 1, wherein the determining an insufficient voltage probability of a vehicle based on the target internal resistance and the historical vehicle data set comprises:

determining whether the target internal resistance is greater than preset internal resistance; and

when the target internal resistance is greater than the preset internal resistance, determining the insufficient voltage probability of the vehicle based on the historical vehicle data set.

7. The method for predicting an insufficient voltage probability of a vehicle according to claim 1, wherein the historical vehicle data set comprises: a historical warning record for an abnormality of the vehicle, a number of times the vehicle fails to start, a number of times the vehicle is parked for a preset number of days, a vehicle using habit record of a user, and an average battery power record.

8. The method for predicting an insufficient voltage probability of a vehicle according to claim 1, wherein the cloud server further communicates with a mobile terminal, and the method further comprises: when the insufficient voltage probability is greater than a warning threshold, sending a prompt signal to the mobile terminal and the vehicle infotainment apparatus.

9. A cloud server, comprising:

a memory, configured to store instructions; and
a processor, configured to invoke the instructions from the memory and capable of implementing, when executing the instructions, the method for predicting an insufficient voltage probability of a vehicle according to any one of claims 1 to 8.

10. A system for predicting an insufficient voltage probability of a vehicle, comprising:

the cloud server according to claim 9; and
a vehicle infotainment apparatus, communicating with the cloud server and configured to upload a plurality of initial starting data sets of a storage battery to the cloud server and receive a prompt signal sent by the cloud server.

11. The system for predicting an insufficient voltage probability of a vehicle according to claim 10, further comprising:
a mobile terminal, communicating with the cloud server and configured to receive the prompt signal sent by the cloud server.

12. A machine-readable storage medium, wherein instructions are stored on the machine-readable storage medium, and the instructions are used for enabling a machine to perform the method for predicting an insufficient voltage probability of a vehicle according to any one of claims 1 to 8.

200    100    300

| Vehicle infotainment apparatus | Cloud server | Mobile terminal |

Fig. 1

101

Obtain a plurality of initial starting data sets of a storage battery uploaded by a vehicle infotainment apparatus within preset time respectively

102

Determine, based on each initial starting data set by using a target internal resistance prediction algorithm, predicted internal resistance corresponding to each initial starting data set, to obtain a plurality of pieces of predicted internal resistance

103

Determine target internal resistance based on the plurality of pieces of predicted internal resistance

104

Obtain a historical vehicle data set uploaded by the vehicle infotainment apparatus

105

Determine an insufficient voltage probability of a vehicle based on the target internal resistance and the historical vehicle data set

Fig. 2

~ 201

| Perform classification based on vehicle identification numbers, and calculate internal resistance values corresponding to different vehicles |

~ 202

| Discard a column unrelated to internal resistance calculation |

~ 203

| Perform sorting based on timestamps |

~ 204

| Delete duplicate data |

~ 205

| Perform data fusion |

~ 206

| Perform logical relationship matching |

Fig. 3

Fig. 4(a)

Fig. 4(b)

Fig. 4(c)

Fig. 4(d)

Fig. 4(e)

Fig. 4(f)

Fig. 4(g)

Fig. 4(h)

Fig. 4(i)

Fig. 4(j)

Fig. 4(k)

Fig. 4(l)

Fig. 4(m)

Fig. 4(n)

Fig. 4(o)

Fig. 5

## EUROPEAN SEARCH REPORT

Application Number

EP 23 21 3518

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AU 2021 204 479 A1 (INTELEMATICS AUSTRALIA PTY LTD [AU]) 20 January 2022 (2022-01-20) | 1-4,9, 10,12 | INV. B60L3/00 |
| Y | * paragraph [0001] - paragraph [0115]; figures 1,7,10a * | 5-8,11 | B60L58/14 B60L58/16 G01R31/36 |
| A | Jerry Wan: "State of Health - Battery Design", , 7 December 2021 (2021-12-07), XP093153848, Retrieved from the Internet: URL:https://www.batterydesign.net/battery-management-system/state-of-health/ [retrieved on 2024-04-19] * page 1 - page 2 * | 1-12 | G01R31/367 G01R31/389 |
| Y | US 2019/176639 A1 (KUMAR PANKAJ [US] ET AL) 13 June 2019 (2019-06-13) | 5-8,11 | |
| A | * paragraph [0006] - paragraph [0161] * | 1-4,9, 10,12 | |

TECHNICAL FIELDS SEARCHED (IPC)

B60L
G01R

The present search report has been drawn up for all claims

| Place of search | Date of completion of the search | Examiner |
|---|---|---|
| The Hague | 6 May 2024 | Cuk, Vladimir |

EPO FORM 1503 03.82 (P04C01)

## ANNEX TO THE EUROPEAN SEARCH REPORT
## ON EUROPEAN PATENT APPLICATION NO.

EP 23 21 3518

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2024

| Patent document cited in search report | | Publication date | Patent family member(s) | | Publication date |
|---|---|---|---|---|---|
| AU 2021204479 | A1 | 20-01-2022 | AU 2021204479 | A1 | 20-01-2022 |
| | | | US 2021405104 | A1 | 30-12-2021 |
| US 2019176639 | A1 | 13-06-2019 | CN 109901075 | A | 18-06-2019 |
| | | | DE 102018131626 | A1 | 13-06-2019 |
| | | | US 2019176639 | A1 | 13-06-2019 |

EPO FORM P0459

For more details about this annex : see Official Journal of the European Patent Office, No. 12/82